(19) Europäisches Patentamt
European Patent Office
Office européen des brevets

(11) Veröffentlichungsnummer: **0 062 698 B1**

(12) **EUROPÄISCHE PATENTSCHRIFT**

(45) Veröffentlichungstag der Patentschrift: **10.07.85**

(51) Int. Cl.[4]: **H 03 K 21/02,** G 01 P 3/489

(21) Anmeldenummer: **81109045.5**

(22) Anmeldetag: **27.10.81**

(54) **Auswerteschaltung für einen digitalen Drehzahlgeber.**

(30) Priorität: **08.04.81 DE 3114221**

(43) Veröffentlichungstag der Anmeldung: **20.10.82 Patentblatt 82/42**

(45) Bekanntmachung des Hinweises auf die Patenterteilung: **10.07.85 Patentblatt 85/28**

(84) Benannte Vertragsstaaten: **AT BE CH DE FR GB IT LI NL SE**

(56) Entgegenhaltungen:
**DE - A - 2 654 211**
**DE - B - 2 160 247**
**DE - B - 2 540 526**

(73) Patentinhaber: **Siemens Aktiengesellschaft, Berlin und München Wittelsbacherplatz 2, D-8000 München 2 (DE)**

(72) Erfinder: **Claussen, Ulf, Dr., Wacholderstrasse 9, D-2000 Wedel (DE)**

EP 0 062 698 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

**Beschreibung**

Die Erfindung betrifft eine Auswerteschaltung nach dem Oberbegriff des Patentanspruchs 1.

Im Handel erhältliche Drehzahlgeber weisen im allgemeinen zwei Impulskanäle auf, auf denen jeweils eine Impulsreihe abgegeben wird, deren Frequenz der Drehzahl proportional ist. Die Impulsreihen sind dabei im Idealfall um 90° phasenverschoben, wobei sich in Abhängigkeit von der Drehrichtung eine Vor- oder Nacheilung der Impulsreihe des zweiten Kanals gegenüber dem ersten Kanal ergibt. Es wird angestrebt, der Drehzahlmessung eine möglichst hohe Frequenz zugrunde zu legen. Bei Auswertung über einen Glättungskondensator kann dann bei gleicher Welligkeit ein Glättungskondensator mit kleinerer Kapazität verwendet werden, so daß die Zeitkonstante klein bleibt. Mit der größeren Signalhäufigkeit folgt bei digitaler Auswertung die Anzeige schneller dem Istwert. Um eine hohe Auswertefrequenz zu erreichen, wird daher bei im Handel erhältlichen Auswerteschaltungen bei jeder positiven und negativen Flanke eines Impulses auf beiden Kanälen ein Auswerteimpuls ausgelöst, so daß eine Impulsreihe mit der vierfachen Frequenz der Impulsreihe auf den beiden Impulskanälen entsteht. Die Drehrichtung wird durch die Bestimmung der positiven oder negativen Phasenverschiebung erfaßt.

Um auch für geringe Drehzahlen eine hohe Auflösung zu erzielen, werden Geber mit hohen Pulszahlen pro Umdrehung verwendet. Entsprechend hochfrequent sind in solchen Fällen die Ausgangssignale bei hoher Drehzahl, deren Frequenz z. B. bei 120 kHz liegen kann. In Verbindung mit nicht zu vermeidenden Unsymmetrien im Geber und unterschiedlichen Laufzeiten in der elektronischen Signalaufbereitung ist insbesondere bei hohen Frequenzen nicht mehr sichergestellt, daß die Impulse beider Impulskanäle einen Phasenabstand von 90° haben. Es kann dann zu zeitlich sehr kurz aufeinanderfolgenden Änderungen im logischen Zustand auf beiden Ausgangskanälen kommen. Da die maximale Verarbeitungsgeschwindigkeit der nachgeschalteten Elektronik z. B. bei C-MOS-Technik bei 1 MHz liegt, besteht die Gefahr, daß diese Änderungen nicht mehr verarbeitet werden können. Wenn die Zeit zwischen zwei Änderungen auf beiden Impulskanälen kürzer wird als die Länge des bei jeder Impulsflanke ausgelösten Auswerteimpulses der Auswerteschaltung, so wird die Änderung nicht mehr erkannt, was zu Fehlauswertungen führt. Die zulässige Frequenz der vom Drehzahlgeber gelieferten Impulsreihen ist damit durch die Breite der Auswerteimpulse begrenzt, wobei das Zusammentreffen aller ungünstigen Toleranzen berücksichtigt werden muß.

Schwierigkeiten treten auch auf, wenn die mit der Auswerteschaltung erzeugte Impulsreihe in einer taktgesteuerten Schaltung, also z. B. in einem Rechnen weiterverarbeitet werden soll, da die Impulsreihe nicht mit dem Takt synchronisierbar ist.

Eine Auswerteschaltung der eingangs genannten Art ist aus der DE-B2-2 160 247 bereits bekannt. Dabei wird zur Drehrichtungsermittlung ebenso wie bei der vorliegenden Erfindung ein jeweils spezifisches Binärmuster aus der ersten und zweiten Impulsreihe des Drehzahlgebers verwendet.

Aufgabe der Erfindung ist es, eine Auswerteschaltung der eingangs genannten Art mit kleinem Schaltungsaufwand so auszugestalten, daß die drehzahlproportionale Impulsreihe synchron zu einem Taktimpulsraster ist und daß die Schaltung ohne prinzipbedingte Frequenzgrenze arbeitet.

Diese Aufgabe wird erfindungsgemäß durch die kennzeichnenden Merkmale des Patentanspruchs 1 gelöst.

Bei der erfindungsgemäßen Auswerteschaltung wird eine Impulsreihe abgegeben, die synchron zum Taktsignal eines Taktgebers liegt. Die Abstände der Impulse innerhalb der ersten und zweiten Impulsreihe oder zwischen den beiden Impulsreihen können zumindest prinzipiell beliebig klein werden.

Der dabei benötigte Code-Wandler kann gemäß der vorteilhaften Ausgestaltung nach Anspruch 2 als einfaches Exclusiv-Oder-Gatter ausgestaltet werden.

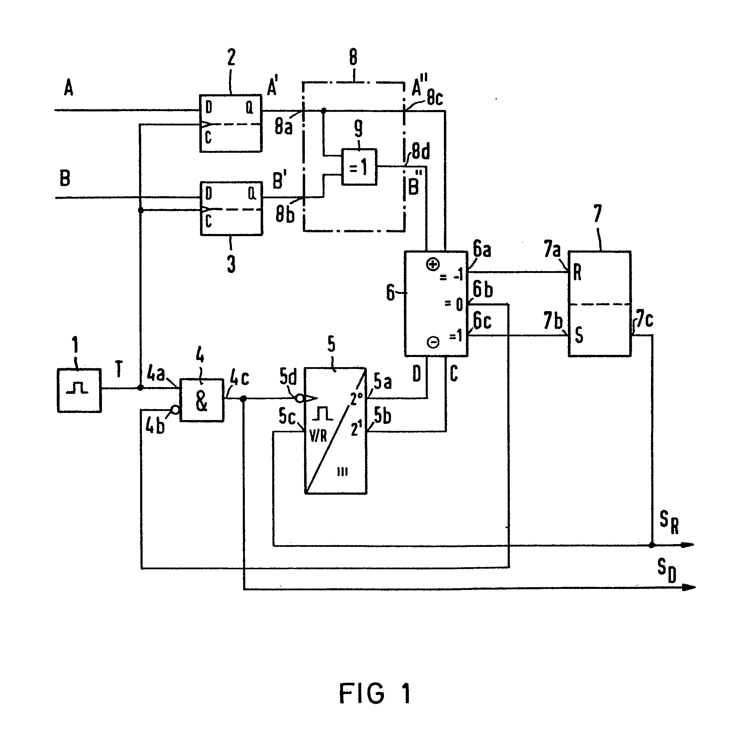

Ein Ausführungsbeispiel der Erfindung wird im folgenden anhand der Figuren 1 bis 3 näher erläutert.

Figur 1 zeigt ein Schaltbild der Auswerteschaltung. Die auf den Impulskanälen A bzw. B ankommenden Impulsreihen eines in Fig. 1 nicht dargestellten Drehzahlgebers werden jeweils dem Eingang D des mit positiver Taktflanke am Takteingang C gesteuerten Signalspeichers 2 bzw. 3 zugeführt. Die Takteingänge C der Signalspeicher 2 und 3 sind mit dem Ausgang des Taktgebers 1 verbunden. Am Ausgang Q des Signalspeichers 2 bzw. 3 steht das mit A' bzw. B' bezeichnete Signal an, das dem Eingang 8a bzw. 8b eines Code-Wandlers 8 zugeführt ist. Der Code-Wandler 8 enthält ein Exclusiv-Oder-Gatter 9, dessen Eingänge mit den Eingängen 8a und 8b verbunden sind. Der Ausgang des Exclusiv-Oder-Gatters 9 ist mit dem Ausgang 8d und der Eingang 8a ist direkt mit dem Ausgang 8c des Code-Wandlers 8 verbunden. Der Taktimpuls T wird außerdem über ein UND-Gatter 4, das, wie nachfolgend noch erläutert wird, in diesem Fall als elektronischer Schalter wirkt, mit einem die negativen Flanken der Taktimpulse zählenden Vor-Rückwärts-Zähler 5 verbunden. Der Steuereingang 5c für Vor-Rückwärts-Betrieb ist mit dem Ausgang eines noch zu erläuternden Vorzeichenspeichers 7 verbunden. Die an den Ausgängen 8c bzw. 8d des Code-Wandlers 8 und die an den Ausgängen 5a bzw. 5b des Vor-Rückwärts-Zählers 5 anstehenden Signale werden mit dem Vergleicher 6 verglichen. Der Vergleicher 6 kann z. B. eine einfache binäre Subtraktionsschaltung sein, die das an den Ausgängen 5a, 5b anstehende Binär-Signal von dem an den Ausgängen 8c, 8d anstehenden Binär-Signal subtrahiert. Am Ausgang 6a des Vergleichers steht dabei ein »1«-Signal an, wenn das Subtraktionsergebnis −1 ist, am Ausgang 6b steht ein »1«-Signal an, wenn das Subtraktionsergebnis 0 ist und am Ausang 6c steht ein »1«-Signal an, wenn das Subtraktionsergebnis +1 ist. Die ebenfalls möglichen Ergebnisse +2 und −2 werden nicht ausgewertet. Der Ausgang 6a ist mit dem Rücksetzeingang 7a und der Ausgang 6c mit dem Setzeingang 7b des Vorzeichenspeichers 7 verbunden. Der Ausgang 6b der Vergleicherstufe 6 ist mit einem negierten Eingang 4b des UND-Gatters 4 verbunden. Der der Setzseite zugeordnete Ausgang 7c des Vorzeichenspeichers 7 ist mit dem Vor-Rückwärts-Steuereingang 5c des Vor-Rückwärts-Zählers 5 verbunden und steuert diesen in den Vorwärtszählbetrieb, wenn am Ausgang 7c ein »1«-Signal ansteht.

Das gewünschte Signal $S_R$ für die Drehrichtung steht am Ausgang 7c des Vorzeichenspeichers 7 an und die gewünschte drehzahlproportionale Ausgangsimpulsfolge $S_D$ wird zwischen UND-Gatter 4 und Eingang 5d des Vor-Rückwärts-Zählers 5 abgegriffen.

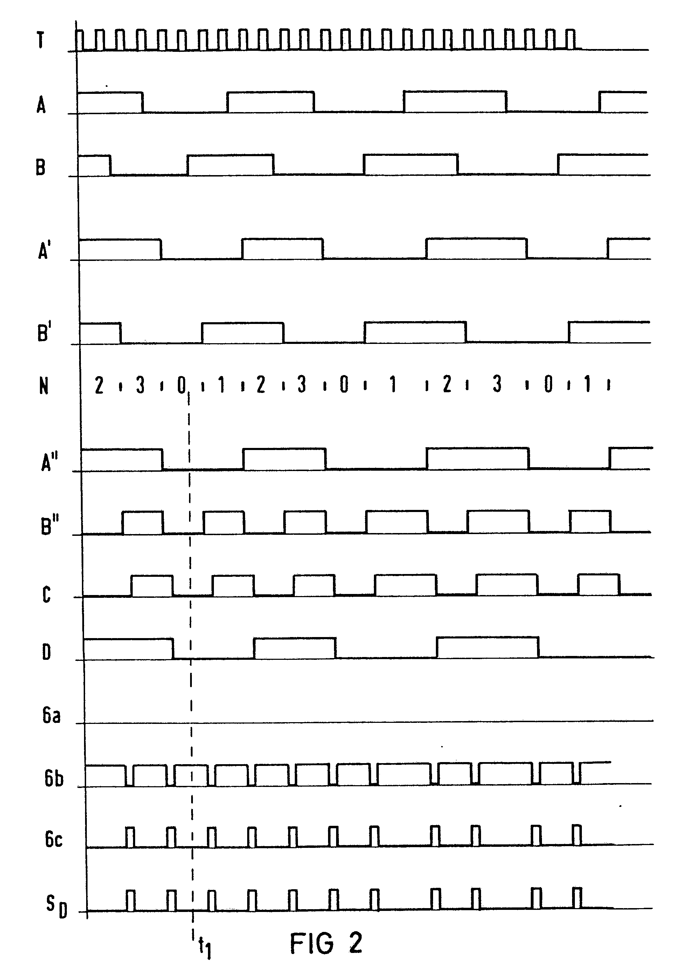

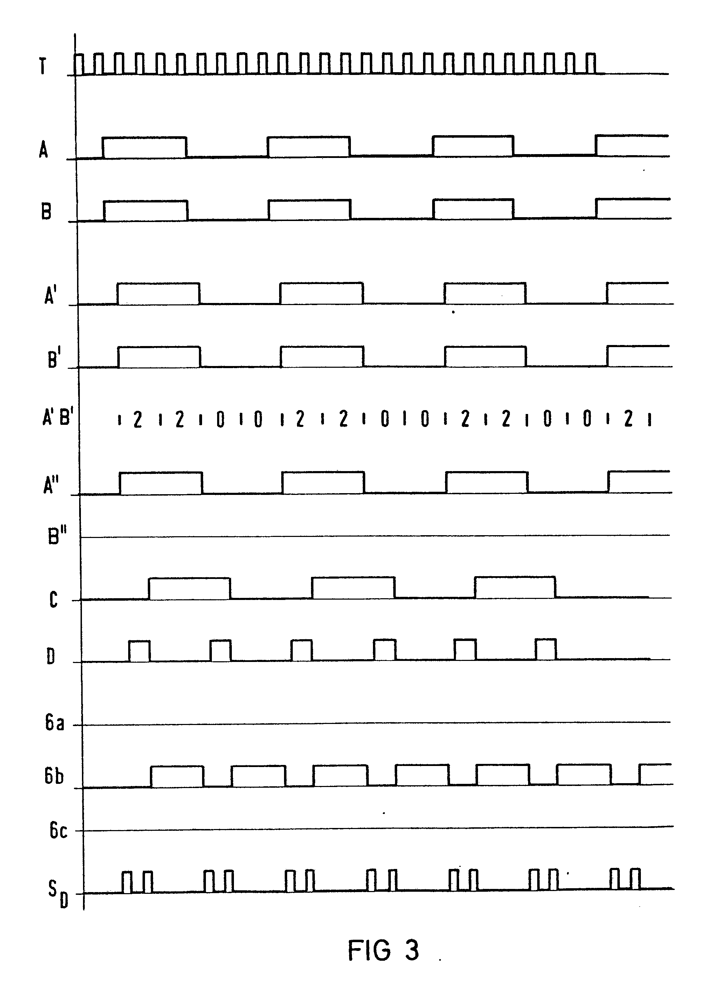

Die Funktion der Schaltungsanordnung wird im folgenden anhand der Impulsdiagramme nach Fig. 2 und 3 näher erläutert.

Fig. 2 zeigt die Impulsfolge bei unverzerrten Impulsreihen A und B. Die Impulse der Impulsreihe B weisen dabei bei angenommener positiver Drehrichtung eine Voreilung von 90° gegenüber den Impulsen der Impulsreihe A auf. Die Impulsreihen A und B werden nun mit dem Takt T gesteuert in die Signalspeicher 2 bzw. 3 übernommen, d. h. jeder Speicher wechselt mit der auf einen Wechsel der Impulse A bzw. B folgenden positiven Taktflanke seinen Speicherzustand. Die in Fig. 2 dargestellten Ausgangsimpulse sind mit A′ bzw. B′ bezeichnet. Die Signale A′ und B′ weisen nun vier mögliche Kombinationen auf, die in Fig. 2 in der Reihenfolge ihres Auftretens mit Nummern 0 bis 3 gekennzeichnet sind. Dabei bedeutet:

0: $A' = 0$, $B' = 0$;
1: $A' = 0$, $B' = 1$;
2: $A' = 1$, $B' = 1$;
3: $A' = 1$, $B' = 0$.

Diese Kombinationen treten in an sich bekannter Weise bei positiver Drehrichtung stets in derselben Reihenfolge auf: 0, 1, 2, 3, 0 ..., bei negativer Drehrichtung in der umgekehrten Reihenfolge: 3, 2, 1, 0, 3 ... Die einzelnen Kombinationen A′ bzw. B′ werden mit dem Code-Wandler 8 in der Reihenfolge ihres Auftretens bei positiver Drehrichtung mit ansteigenden Dualzahlen entsprechend den obengenannten Dezimalzahlen gekennzeichnet. Die dabei entstehenden Signale sind mit A″ bzw. B″ gekennzeichnet. Dabei soll B″ das geringerwertige Bit sein, so daß für 1: $B''=1$, für 2: $A''=1$, für 3: A″ und $B''=1$ gilt. Wie das Diagramm nach Fig. 2 zeigt, ist dabei A″ identisch mit A′, so daß der entsprechende Eingang 8a direkt mit dem entsprechenden Ausgang 8c verbunden werden kann. Das Signal B″ ergibt sich aus der Exclusiv-Oder-Funktion 9.

Damit steht also mit der Binärsignalkombination bzw. Dualzahl A″, B″ eine Information über die Lage des Drehzahlgebers zur Verfügung. Entsprechend dieser Information soll nun der Zähler 5 dem tatsächlichen vorhandenen Wert nachgeführt werden. An den Ausgängen 5a und 5b steht ebenfalls ein Wertepaar C, D als Dualzahl an. Die Dualzahl D, C wird von der Dualzahl A″, B″ subtrahiert und das Subtraktionsergebnis wird zur Steuerung des Zählers 5 ausgewertet.

Zur Erläuterung wird zunächst davon ausgegangen, daß sowohl die Dualzahl A″, B″ als auch die Dualzahl C, D Null ist, d. h. von dem in Fig. 2 gestrichelt eingezeichneten Zeitpunkt $t_1$. Damit ist das Subtraktionsergebnis des Vergleichers 6 Null, so daß am Ausgang 6b des Vergleichers 6 ein »1«-Signal ansteht. Dieses »1«-Signal hält den Ausgang 4c des UND-Gatters 4 auf »0«, so daß die Taktflanken des Taktgebers 1 nicht auf den Zähleingang 5d des Zählers 5 durchgeschaltet werden. Der Zählerstand des Zählers 5 bleibt daher unverändert.

Wechselt nun B″ nach 1, also die Dualzahl A″, B″ ebenfalls nach »1«, so stellt der Vergleicher 6 eine Abweichung von +1 fest, d. h. der Ausgang 6c geht, wie in Fig. 2 dargestellt, auf »1«. Das stellt zugleich auch eine Information über die Drehrichtung dar, da aus der Abweichung »+1« geschlossen werden kann, daß die Zahlenfolge in der Richtung 0, 1, 2, 3, durchlaufen wird, also eine positive Drehrichtung vorliegt. Mit diesem Signal wird daher der Speicher 7 auf die Setzseite gesetzt, so daß am Ausgang 7c des Speichers 7 ein »1«-Signal ansteht. Dieses Signal wird als Drehrichtungs-Signal $S_R$ ausgewertet. Außerdem ist es dem Vor-Rückwärts-Steuereingang 5c des Vor-Rückwärts-Zählers 5 zugeführt, der damit auf Vorwärts-Zählrichtung schaltet. Da mit dem Erscheinen des »1«-Signals am Ausgang 6c gleichzeitig das »1«-Signal am Ausgang 6b verschwindet, werden nunmehr die Taktimpulse über das UND-Gatter 4 freigegeben. Mit der folgenden negativen Impulsflanke des Taktimpulses T wird damit der Zähler 5 um 1 weitergeschaltet, d. h. der Ausgang C geht auf »1«. Damit wird die Differenz der Dualzahlen A″, B″ und C, D wieder Null und der Taktimpuls wird mit dem UND-Gatter 4 wieder gesperrt, bis wiederum eine Abweichung zwischen den genannten Dualzahlen auftritt. Der Inhalt des Zählers 5 wird also, maximal um eine Breite eines Taktimpulses versetzt, der die Stellung des Drehzahlgebers kennzeichnenden Dualzahl A″, B″ nachgeführt. Das ebenfalls in Fig. 2 dargestellte Ausgangssignal $S_D$ des UND-Gatters 4 enthält entsprechend den vier Signalzuständen der Signalkombination A′, B′ vier Impulse je Periode des Signals A oder B. Damit steht die gewünschte drehzahlproportionale Impulsreihe mit der vierfachen Frequenz des Signals A bzw. B zur Verfügung. Das Signal

$S_D$ stellt somit das gewünschte Ausgangssignal dar. Die geringe Zeitverschiebung gegenüber den ursprünglichen Impulsreihen A, B beträgt maximal eine Periode des Taktsignals T. Da dieses verhältnismäßig hochfrequent ist, z. B. im Bereich von einem MHz liegt, ist diese Signalverzögerung sehr klein, z. B. in der Größenordnung von einer µsek., so daß es sich in der Praxis nicht störend auswirkt.

Wenn sich die Drehrichtung umkehrt, ist die Funktion der Auswerteschaltung analog. In diesem Fall wird die Signalkombination A' bzw. B' in der umgekehrten Richtung durchlaufen. Die entsprechenden kennzeichnenden Zahlen laufen also in negativer Richtung: 3, 2, 1, 0, 3... Damit stellt der Vergleicher 6 bei jeder Flanke der Signale A', B' eine negative Abweichung der Zahl A", B" gegenüber der Zahl C, D fest, wenn vorher keine Abweichung besteht. Der Signalspeicher 7 wird somit auf die Reset-Seite gesetzt. Das Signal $S_R$ geht auf Null, so daß die negative Drehrichtung angezeigt wird. Außerdem wird der Zähler 5 auf Rückwärtszählbetrieb umgeschaltet, so daß er ebenfalls in Rückwärtsrichtung zählt: 3, 2, 1, 0, 3... Damit wird der Zähler 5 auch bei negativer Drehrichtung der mit der Zahl A", B" gekennzeichneten Drehzahlgeberstellung nachgeführt und das Signal $S_D$ stellt wieder eine drehzahlproportionale Impulsreihe mit der vierfachen Frequenz der Impulsreihen A, B dar.

Anhand von Fig. 2 wurde damit die Funktion der Auswerteschaltung für symmetrische Impulsreihen A, B, d. h. bei der idealen Phasenverschiebung von 90° zwischen den beiden Impulsreihen A, B beschrieben. Wie im folgenden anhand von Fig. 3 erläutert, liefert die beschriebene Auswerteschaltung jedoch auch noch dann richtige Ergebnisse, wenn der Phasenabstand zwischen einem Impuls der Impulsreihe A und dem korrespondierenden Impuls der Impulsreihe B sehr klein wird oder sogar auf Null geht. Kleine Impulsabstände können z. B. bei hohen Drehzahlen aufgrund von Unsymmetrien im Geber und unterschiedlichen Laufzeiten in der Auswerteschaltung auftreten.

In Fig. 3 ist der Extremfall dargestellt, daß zwischen den Impulsen der Impulsreihen A und B kein Zustand mehr besteht. Die Impulse der Impulsreihen A und B werden mit den Taktimpulsen T in die Signalspeicher 2 und 3 übernommen. Die Impulsreihen A' und B' sind dann identisch. Damit treten nur noch die nach vorheriger Definition mit den Nummern 0 und 2 gekennzeichneten Impulszustände auf. Dies bedeutet, daß nach der binären Umkodierung im Code-Wandler 8 das Signal B" auf Null bleibt, während das Signal A" wieder identisch mit dem Signal A' ist. Eine genauere Betrachtung der Signalkombination A', B' ergibt, daß diese keine Information über die Drehrichtung enthält, da die Signalfolge 0, 2, 0... sowohl bei Vorwärts- als auch bei Rückwärtslauf auftritt. Im Vorzeichenspeicher 7 ist aber noch ein Signal für die Drehrichtung abgespeichert. Im praktischen Betrieb kann davon ausgegangen werden, daß die Drehrichtung nicht plötzlich wechselt, sondern daß bei einem Drehrichtungwechsel stets vorübergehend niedrige Drehzahlbereiche durchlaufen werden, bis sich eine hohe Drehzahl in der anderen Richtung aufbauen kann. Bei niedrigen Drehzahlen sind jedoch die auftretenden Impulsverzerrungen geringer, so daß beim Durchgang durch niedrige Drehzahlen das Vorzeichen wieder richtig ausgewertet werden kann. Es kann daher davon ausgegangen werden, daß der Speicher 7 stets das richtige Vorzeichen enthält.

Die Betrachtung der Impulskombination A', B' ergibt außerdem, daß diese zwar von den vier möglichen Signalkombinationen nur noch zwei enthält, daß jedoch andererseits eine Information über die fehlenden Signalkombinationen vorliegt, da zwischen den Zahlen 0 und 2 eine 1 und zwischen 2 und 0 eine 3 liegen muß. Dies wird, wie im folgenden beschrieben, in der Auswerteschaltung zur Rekonstruktion der richtigen Impulsreihe ausgewertet. Es wird zunächst davon ausgegangen, daß sowohl die Zahl A", B" als auch die Zahl C, D Null ist, so daß am Vergleicherausgang 6b eine »1« ansteht, die über das UND-Gatter 4 die Taktimpulse sperrt. Wenn nun die Zahl A", B" auf 2 springt, so beträgt die Abweichung zur Zahl C, D+2 und das »1«-Signal am Ausgang 6d verschwindet, so daß die Taktimpulse wieder durchgelassen werden. Der Zähler 5 erreicht nun nach zwei Taktimpulsen ebenfalls die Zahl 2, so daß der Vergleicherausgang 6b wieder auf »1« geht und die Taktimpulse sperrt. Wenn die Zahl A", B" wieder auf Null springt, so werden wieder zwei Taktimpulse freigegeben, die den Zähler 5 ebenfalls auf den Zählerstand Null bringen. Der Zählerstand des Zählers 5 folgt also wiederum mit einer gewissen Zeitverzögerung der die Drehzahlgeberstellung kennzeichnenden Zahl A", B". Auch im dargestellten Extremfall erzeugt also die Auswerteschaltung eine drehzahlproportionale Impulsfolge mit der vierfachen Frequenz der Impulsreihe A bzw. B. Der Fall, daß zwei Impulsflanken der Impulsreihen A und B zeitlich nicht mehr voneinander unterschieden werden können, kann immer dann auftreten, wenn sie innerhalb einer Taktperiode des Taktes T liegen, da innerhalb einer Periode stattfindende Ereignisse als gleichzeitig ausgewertet werden. Wie erläutert, beeinträchtigt dies jedoch nicht die exakte Auswertung der Impulsreihen.

Im Vergleich dazu würde die eingangs erwähnte, bekannte Auswerteschaltung, die mit jeder Impulsflanke der Impulsreihe A und B einen kurzen Impuls auslöst, bei kleinen Phasenabweichungen zwischen den Impulsreihen A und B plötzlich nur noch die zweifache Frequenz liefern und somit zu völlig falschen Meßergebnissen führen.

Die Funktion der Auswerteschaltung bei negativen Drehzahlen ist auch bei dem anhand von Fig. 3 dargestellten Fall der extremen Unsymmetrie analog zur Funktion bei positiver Drehrichtung.

Bei der beschriebenen Auswerteschaltung muß also keine prinzipbedingte Grenze für die Abstände der einzelnen Impulse der Impulsreihen A und B eingehalten werden. Lediglich eine Impulsverschiebung über 90° hinaus, d. h. ein negativer Abstand zwischen den Impulsen würde, bedingt durch das Prinzip des Drehzahlgebers an sich, zu einer falschen Drehrichtungsauswertung führen. Dies muß selbstverständlich durch entsprechenden Aufbau des Drehzahlgebers selbst verhindert werden. Da bei der beschriebenen Auswerteschaltung die drehzahlproportionale Impulsreihe aus ausgeblendeten Taktimpulsen besteht, ist ein Synchronismus zu einem, beispielsweise von einem Rechner vorgegebenen Taktimpuls hergestellt. Damit wird die Verarbeitung des Signals in einem Rechner entscheidend erleichtert.

**Patentansprüche**

1. Auswerteschaltung für eine digitalen Drehzahlgeber, die das aus einer in Abhängigkeit von der Drehrichtung phasenverschobenen, drehzahlproportionalen ersten und zweiten Impulsreihe (A, B) bestehende Ausgangssignal des Drehzahlgebers in eine drehzahlproportionale Impulsreihe mit der vierfachen Frequenz der ersten und zweiten Impulsreihe und ein getrenntes Vorzeichensignal umwandelt, wobei ein Taktgeber (1) vorgesehen ist, der ein Taktsignal (T) mit mindestens der vierfachen Frequenz der maximalen Frequenz der ersten bzw. zweiten Impulsreihe (A, B) abgibt, wobei die erste und die zweite Impulsreihe (A, B) einem ersten bzw. zweiten, vom Taktgeber (1) gesteuerten Signalspeicher (2, 3) zugeführt werden, wobei der Taktgeber (1) über einen steuerbaren elektronischen Schalter (4) mit einem die negativen Flanken zählenden Eingang eines binär zählenden Vor-Rückwärtszählers (5) verbunden ist, wobei der Ausgang eines Vorzeichenspeichers (7) mit einem Steuer-Eingang (5c) für Vor-Rückwärts-Zählweise des Vor-Rückwärts-Zählers (5) verbunden ist und wobei das Vorzeichensignal am Ausgang des Vorzeichenspeichers (7) und die drehzahlproportionale Impulsreihe hinter dem steuerbaren elektronischen Schalter (4) abgegriffen wird, dadurch gekennzeichnet, daß zwischen den Ausgängen des ersten und zweiten Signalspeichers (2, 3) und einem Eingang eines Vergleichers (6) ein Code-Wandler (8) angeordnet ist, der die zeitlich aufeinanderfolgenden Signalkombinationen in aufeinanderfolgende Dual-Zahlen umwandelt, daß der Ausgang des Vor-Rückwärts-Zählers (5) mit dem anderen Eingang des Vergleichers (6) verbunden ist, daß die eine positive bzw. negative Abweichung des Zählerstandes um einen Schritt von der vom Code-Wandler (8) ermittelten Dual-Zahl anzeigenden Ausgänge (6a, 6c) des Vergleichers (6) mit dem Set- bzw. Reset-Eingang des Vorzeichenspeichers (7) verbunden sind und daß der die Übereinstimmung des Zählerstandes des Vor-Rückwärts-Zählers (5) und der vom Code-Wandler (8) ermittelten Dual-Zahl mit einem Kennsignal anzeigende Ausgang (6b) des Vergleichers (6) mit einem Steuer-Eingang des steuerbaren elektronischen Schalters (4) verbunden ist und diesen bei Vorliegen des Kennsignals öffnet.

2. Auswerteschaltung nach Anspruch 1, dadurch gekennzeichnet, daß der erste Eingang (8a) des Code-Wandlers (8) mit dessen erstem Ausgang (8c) unmittelbar verbunden ist und daß der erste und der zweite Eingang (8a, 8b) des Code-Wandlers (8) mit den Eingängen eines Exclusiv-ODER-Gatters (9) verbunden sind, dessen Ausgang mit dem zweiten Ausgang (8d) des Code-Wandlers (8) verbunden ist.

**Claims**

1. An evaluation circuit for a digital rotational speed transducer which converts the output signal of the rotational speed transducer, consisting of first and second rotational-speed-proportional pulse sequences (A, B) which are phasedispaced in dependence upon the rotation direction, into a rotational-speed-proportional pulse sequence having four times the frequency of the firs and second pulse sequences, and a separate sign signal, where a clock pulse generator (1) is provided which emits a clock pulse signal (T) having a frequency at least for times that of the maximum frequency of the first and second pulse sequences (A, B), where the first and second pulse sequences (A, B) are fed respectively to a first and second signal store (2, 3) controlled by the clock pulse generator (1), where the clock pulse generator (1) is connected via a controllable, electronic switch (4) to an input of a binary-counting forwards-backwards counter (5) which counts the negative flanks, where the output of a sign store (7) is connected to a control input (5c) for forwards-backwards counting of the forwards-backwards counter (5), and where the sign signal is tapped from the output of the sign store (7), and the rotational-speed-proportional pulse sequence is tapped following the controllable electronic switch (4), characterised in that between the outputs of the first and second signal stores (2, 3) and an input of a comparator (6) there is arranged a code converter (8) which converts the signal combinations, which follow one another in time, into consecutive dual numbers, that the output of the forwards-backwards counter (5) is connected to the other input of the comparator (6), that the outputs (6a, 6c) of the comparator (6), which indicate a positive or negative deviation in the count, by one step, from the dual number determined by the code converter (8), are connected to the set and reset input of the sign store (7), and that that output (6b) of the comparator (6) which indicates the identity of the count of the forward-backwards counter (5) and the dual number determined by the code converter (8) by a code signal is connected to a control input of the controllable electronic switch (4) which it opens when the code signal occurs.

2. An evaluation circuit as claimed in Claim 1, characterised in that the first input (8a) of the code converter (8) is directly connected to its first output (8c), and that the first and second inputs (8a, 8b) of the code converter (8) are connected to the inputs of an EXCLUSIVE-OR gate (9) whose output is connected to the second output (8d) of the code converter (8).

**Revendications**

1. Montage d'évaluation pour un transmetteur numérique de vitesse de rotation, qui transforme le signal de sortie du transmetteur de vitesse de rotation, consistant en un premier et un second train d'impulsions (A, B) proportionnels à la vitesse de rotation et déphasés en fonction du sens de rotation, en un train d'impulsions proportionnel à la vitesse de rotation ayant une fréquence quadruple de celle des premier et second trans d'impulsions et un signal de signe séparé, comprenant un rythmeur (1) qui délivre un signal de rythme (T) d'une fréquance au moins quadruple de la fréquence maximale du premier ou second train d'impulsions (A, B), les premier et second trans d'impulsions (A, B) étant appliqués à une première respectivement seconde mémoire de signaux (2, 3) commandée par le rythmeur (1), le rythmeur (1) étant relié à travers un commutateur électronique commandé (4) à une entrée de comptage des flancs négatifs d'un compteur-décompteur binaire (5), la sortie d'une mémoire de signe (7) étant connectée à une entrée de commande (5c) pour le mode de comptage, progressif ou régressif, du compteur-décompteur (5), le signal de signe étant prélevé à la sortie de la mémoire de signe (7) et le train d'impulsions proportionnel à la vitesse de rotation étant prélevé derrière le commutateur électronique commande (4), caractérisé en ce qu'un transcodeur (8) disposé entre les sorties des première et seconde mémoires de signal (2, 3) et une entrée d'un comparateur (6) transforme les combinaisons de signaux qui se suivent dans le temps en nombres doubles successifs, que la sortie du compteur-décompteur (5) est connectée à l'autre entrée du comparateur (6), que les sorties (6a, 6c) du comparateur (6), indiquant un écart positif ou négatif d'un pas entre la position du compteur et le nombre double déterminé par le transcoduer (8), sont connectées à l'entrée de mise à 1 respectivement l'entrée de mise à zéro de la mémoire de signe (7) et que le comparateur (6) possède une sortie (6b) qui indique par un signal indicatif la concordance entre la position du compteur-décompteur (5) et le nombre double déterminé par le transcodeur (8) et qui est connectée à une entrée de commande du commutateur électronique (4), lequel est ouvert en cas de présence du signal indicatif sur cette sortie.

2. Montage d'évaluation selon la revendication 1, caractérisé en ce que la première sortie (8a) du transcodeur (8) est connectée directement à sa première sortie (8c) et que les première et seconde entrées (8a, 8b) du transcodeur (8) sont connectées aux entrées d'un élément OU exclusif (9), dont la sortie est reliée à la seconde sortie (8d) du transcodeur (8).

2
8
A
A'
A''
8c
D
Q
C
8a
9
=1
8d
B
B'
B''
D
Q
C
8b
3
7
6a
7a
⊕
= -1
R
6
6b
= 0
6c
7b
7c
=1
S
⊖
1
T
4
5
4a
4c
5d
D
C
5a
&
2°
4b
5c
5b
V/R
2¹
$S_R$
$S_D$

FIG 1

T
A
B
A'
B'
N
2 3 0 1 2 3 0 1 2 3 0 1
A''
B''
C
D
6a
6b
6c
$S_D$
$t_1$

FIG 2

T
A
B
A'
B'
A' B'
2 2 0 0 2 2 0 0 2 2 0 0 2
A''
B''
C
D
6a
6b
6c
$S_D$

FIG 3